# EUROPÄISCHE PATENTANMELDUNG

(11) **EP 3 392 906 A1**
(43) Veröffentlichungstag der Anmeldung: **24.10.2018**
(21) Anmeldenummer: 17167066.4
(22) Anmeldetag: 19.04.2017
(51) Int. Cl.: H01L 23/373, H01L 23/473, H01L 21/48, F28F 3/00, F28F 7/02, F28F 13/00, F28F 13/12

(54) **VERFAHREN ZUR HERSTELLUNG EINER KÜHLPLATTE FÜR EINEN LEISTUNGSHALBLEITER**

(71) Anmelder: Siemens Aktiengesellschaft, 80333 München (DE)
(72) Erfinder: Danov, Vladimir, 91056 Erlangen (DE); Ippisch, Stephan, 91054 Erlangen (DE); Knauer, Hans, 91359 Leutenbach (DE); Kneißl, Philipp, 90768 Fürth (DE)

(57) **Zusammenfassung**

Es wird ein Verfahren zur Herstellung einer Kühlplatte (1) für einen Leistungshalbleiter vorgeschlagen, das die folgenden Schritte umfasst:
- Bereitstellen eines ersten und zweiten Bleches (2, 4);
- Anordnen eines Füllkörpers (42) zwischen dem ersten und zweiten Blech (2, 4);
- Verpressen der Bleche (2, 4) mit dem zwischen den Blechen (2, 4) angeordneten Füllkörper (42); und
- Stoffschlüssiges Verbinden des ersten und zweiten Bleches (2, 4) an ihren jeweiligen Enden.

Weiterhin betrifft die Erfindung ein Modul mit einem Leistungshalbleiter und einer erfindungsgemäß hergestellten Kühlplatte (1) sowie einen Stromrichter mit einem solchen Modul.

## Beschreibung

Die Erfindung betrifft ein Verfahren zur Herstellung einer Kühlplatte für einen Leistungshalbleiter, insbesondere für einen Bipolartransistor mit isolierter Gate-Elektrode (englisch: Insulated Gate Bipolar Transistor, abgekürzt IGBT). Weiterhin betrifft die Erfindung ein Modul mit einem Leistungshalbleiter, der an einer erfindungsgemäß hergestellten Kühlplatte angeordnet ist und somit bei seinem Betrieb gekühlt wird. Zudem betrifft die Erfindung einen Stromrichter, der wenigstens ein erfindungsgemäßes Modul umfasst.

Bei einem Betrieb eines Stromrichters, insbesondere eines Gleichrichters oder Umrichters, ergeben sich Verlustleistungen, welche auf dem begrenzten Wirkungsgrad der verwendeten elektrischen Komponenten des Stromrichters zurückzuführen sind. Die größten Verlustleistungen weisen beispielsweise Wechselrichter, Symmetriewiderstände, Zwischenkreiskondensatoren oder Zusatzkomponenten, beispielsweise Gleichrichter, auf. Die elektrischen Komponenten erfordern eine stetige Abfuhr der durch ihre Verlustleistung erzeugten Wärme, damit die Betriebssicherheit des Stromrichters sichergestellt ist.

Bekannt ist für die Kühlung von Stromrichtern beziehungsweise ihrer Komponenten eine Luftkühlungen oder eine Flüssigkeitskühlungen zu verwenden. Bei der Flüssigkeitskühlung werden einphasige Kühlungen und zweiphasige Kühlungen (Verdampfungskühlung) unterschieden.

Insbesondere bei einer Flüssigkeitskühlung sind speziell ausgestaltete Kühlkörper oder Kühlplatten erforderlich, die zur Anordnung elektrischer Komponenten, insbesondere Leistungshalbleiter, möglichst eben ausgebildet sind, einen Hohlraum für ein Kühlfluid aufweisen, möglichst kompakt sind und möglichst kostengünstig in ausreichender Stückzahl hergestellt werden können.

Aus dem Stand der Technik sind Kühlplatten bekannt, die mittels tiefgebohrter Kanäle hergestellt werden, durch welche ein Kühlfluid geleitet werden kann. Weiterhin können Kühlplatten mittels eines Einpressens von Rohren in vorab gefräste Nuten hergestellt werden. Zudem können Kühlplatten mittels eines Innenhochdruckumformens (englisch: Hydroforming) hergestellt werden. Ferner sind Kühlplatten aus einer Vergussmasse mit integrierten Kühlkanälen bekannt.

Ein Nachteil der genannten Herstellungsverfahren ist, dass diese vergleichsweise kostenintensiv sind.

Der vorliegenden Erfindung liegt die Aufgabe zugrunde, ein alternatives Herstellungsverfahren bereitzustellen, das insbesondere kostengünstig ist.

Die Aufgabe wird durch ein Verfahren mit den Merkmalen des unabhängigen Patentanspruches 1, durch ein Modul mit den Merkmalen des unabhängigen Anspruches 11 sowie durch einen Stromrichter mit den Merkmalen des unabhängigen Patentanspruches 12 gelöst. In den abhängigen Patentansprüchen sind vorteilhafte Ausgestaltungen und Weiterbildungen der Erfindung angegeben.

Das erfindungsgemäße Verfahren zur Herstellung (Herstellungsverfahren) einer Kühlplatte für einen Leistungshalbleiter, umfasst die folgenden Schritte:
- Bereitstellen eines ersten und zweiten Bleches;
- Anordnen eines Füllkörpers zwischen dem ersten und zweiten Blech;
- Verpressen der Bleche mit dem zwischen den Blechen angeordneten Füllkörper; und
- Stoffschlüssiges Verbinden des ersten und zweiten Bleches an ihren jeweiligen Enden.

Die Kühlplatte kann zur Kühlung weiterer elektrischer Komponenten ausgebildet und/oder vorgesehen sein.

Die erfindungsgemäß hergestellte Kühlplatte ist beispielsweise dadurch gekennzeichnet, dass diese hohe Wärmestromdichten, wie sie beispielsweise bei Leistungshalbleiter auftreten, effizient abführen kann. Hierbei ist die Kühlplatte insbesondere für eine Verdampfungskühlung vorgesehen. Aufgrund des innerhalb der verpressten Bleche angeordneten Füllkörpers bilden sich Keimstellen oder Keimbereiche für ein Sieden eines durch die Kühlplatte geführten Kühlfluids aus. Dadurch wird ein Siedeverzug des Kühlfluids verringert oder möglichst verhindert. Mit anderen Worten ist der Füllkörper als Keimstelle für ein Sieden eines Kühlfluids ausgebildet.

Ein weiterer Vorteil des Füllkörpers ist, dass dieser die Oberfläche für die Wärmeübertragung von der Kühlplatte auf das Kühlfluid verbessert. Dadurch kann eine ausreichende Wärmemenge auch bei einer möglichst geringen Temperaturdifferenz übertragen und abgeführt werden. Hierbei ist es von Vorteil, wenn die Bleche möglichst dünnwandig sind, da dann die Wärme beziehungsweise Abwärme auch ohne einen großen Temperaturgradient abgeführt werden kann. Weiterhin wird durch das erfindungsgemäße Verpressen der Bleche ein besonders guter thermischer Kontakt zwischen den Blechen und den in ihnen angeordneten Füllkörper ermöglicht. Dadurch werden Temperaturspitzen, wie sie insbesondere bei elektronischen Bauteilen, beispielweise Leistungshalbleitern, auftreten, verringert.

Ein weiterer wesentlicher Vorteil des erfindungsgemäßen Verfahrens ist, dass dieses kostengünstig ist.

Hierbei ist es von besonderem Vorteil, wenn als Bleche hochdruckgeformte Bleche verwendet werden.

Gemäß einer vorteilhaften Ausgestaltung der Erfindung werden die ersten und zweiten Bleche mittels eines Schweißverfahrens, insbesondere mittels eines Ultraschallschweißverfahrens, und/oder mittels eines Lötverfahrens stoffschlüssig an ihren jeweiligen Enden verbunden.

Dadurch wird eine mechanisch und thermisch stabile sowie fluidisch dichte Verbindung der zwei Bleche ermöglicht.

In einer vorteilhaften Weiterbildung der Erfindung werden als Füllkörper ein Metallschaum und/oder eine Metallwolle verwendet.

Dadurch wird die Oberfläche, die zur Wärmeübertragung vorgesehen und im thermischen Kontakt mit einem Kühlfluid ist, vergrößert. Hierbei werden die Bleche bevorzugt vorab mittels einer Hochdruckumformung geformt und anschließend zusammen mit dem Metallschaum und/oder mit der Metallwolle verpresst. Durch das Verpressen beziehungsweise Zusammenpressen wird die thermische Anbindung oder Kopplung zwischen dem Metallschaum und/oder der Metallwolle verbessert. Insbesondere ist der Füllkörper hierzu porös ausgebildet.

Gemäß einer vorteilhaften Ausgestaltung der Erfindung wird als Füllkörper ein Druckgussprofil, insbesondere mittels eines Druckgusses hergestellte Rippen, verwendet.

Ein Vorteil der Druckgussprofile ist, dass diese standardisiert sein können. Dadurch können die Herstellungskosten der Kühlplatte weiter verringert werden. Weiterhin wird dadurch ein modularer Aufbau ermöglicht.

Es ist von besonderem Vorteil, wenn als Füllkörper ein Druckgussprofil mit wenigstens einem Sacklochgewinde und einer Dichtung verwendet wird.

Dadurch können elektronische oder elektrische Bauteile, insbesondere Leistungshalbleiter, mit der Kühlplatte verschraubt werden. Weiterhin wird dadurch der Druck, mit welchem das Druckgussprofil an den Blechen anliegt, erhöht. Weiterhin weist die Kühlplatte hierbei zwei im Wesentlichen ebene Seitenflächen auf, an welchen die elektronischen Bauteile, insbesondere Leistungshalbleiter, vorteilhaft angeordnet werden können.

Gemäß einer besonders bevorzugten Ausgestaltung der Erfindung wird als Füllkörper ein mittels eines generativen Fertigungsverfahren, insbesondere mittels eines dreidimensionalen Druckens, hergestelltes Bauteil verwendet.

Dadurch können komplexe geometrische Füllkörper, die beispielsweise zu einer Erhöhung von Turbulenzen des Kühlfluids beim Durchströmen des Füllkörpers führen, bereitgestellt und verwendet werden. Insbesondere ist es von Vorteil die Turbulenzen in einem bezüglich des Füllkörpers oberflächennahen Bereich zu verstärken. Insgesamt wird hierdurch die Wärmeleitfähigkeit der Kühlplatte verbessert.

In einer vorteilhaften Weiterbildung der Erfindung wird wenigstens eines der Bleche mit einer Mehrzahl von Ausbeulungen bereitgestellt.

Dadurch wird insbesondere die mechanische Stabilität des Bleches verbessert. Die Ausbeulungen können mittels einer Hochdruckumformung des Bleches ausgebildet werden. Weiterhin können Bleche mit Lamellen hierzu verwendet werden, wobei die Ausbeulungen mittels der Lamellen gebildet werden.

Es ist von Vorteil, wenn als Füllkörper eine Mehrzahl von einzelnen Druckgussprofilen verwendet wird, und wenn die einzelnen Druckgussprofile vor dem Verpressen oder bei dem Verpressen der Bleche innerhalb der Ausbeulungen angeordnet werden.

Dadurch werden vorteilhafterweise Kühlkanäle für ein Kühlfluid durch die Ausbeulungen ausgebildet.

Hierbei ist es von besonderem Vorteil die zwei Bleche zwischen zwei benachbarten Ausbeulungen stoffschlüssig, insbesondere mittels eines Schweißverfahrens, Ultraschallschweißverfahren und/oder eines Lötverfahrens, miteinander zu verbinden.

Das erfindungsgemäße Modul umfasst wenigstens einen Leistungshalbleiter der an wenigstens einer gemäß der vorliegenden Erfindung oder einer ihrer Ausgestaltungen hergestellten Kühlplatte angeordnet ist.

Der erfindungsgemäße Stromrichter, insbesondere Gleichrichter, Wechselrichter oder Umrichter, umfasst wenigstens ein erfindungsgemäßes Modul.

Es ergeben sich für das erfindungsgemäße Modul sowie für den erfindungsgemäßen Stromrichter zum erfindungsgemäßen Verfahren gleichartige und gleichwertige Vorteile.

Weitere Vorteile, Merkmale und Einzelheiten der Erfindung ergeben sich aus dem im Folgenden beschriebenen Ausführungsbeispielen sowie anhand der Zeichnungen. Dabei zeigen schematisiert:
- Figur 1: ein Flussdiagramm eines Verfahrens zur Herstellung einer Kühlplatte gemäß einer ersten Ausgestaltung der Erfindung;
- Figur 2: ein Flussdiagramm eines Verfahrens zur Herstellung einer Kühlplatte gemäß einer zweiten Ausgestaltung der Erfindung; und
- Figur 3: ein Flussdiagramm eines Verfahrens zur Herstellung einer Kühlplatte gemäß einer dritten Ausgestaltung der Erfindung.

Gleichartige, gleichwertige oder gleichwirkende Elemente können in den Figuren mit denselben Bezugszeichen versehen sein.

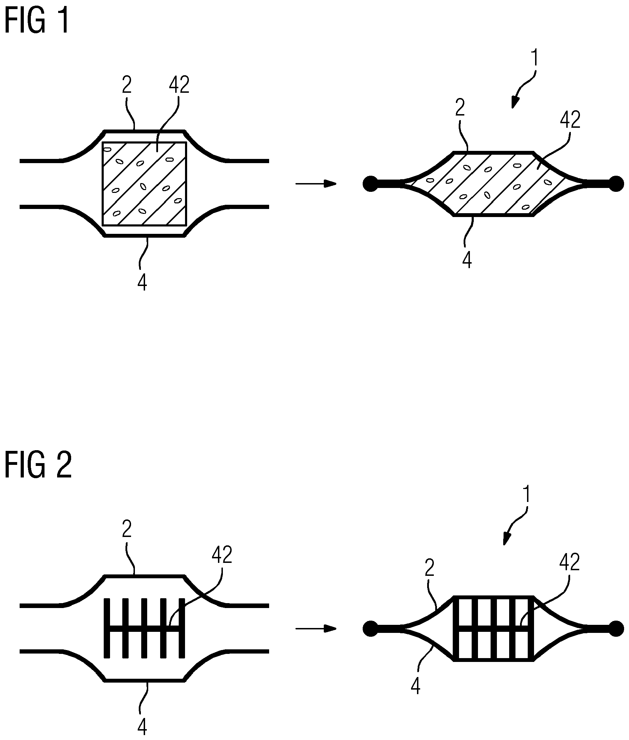

In der Figur 1 ist ein Flussdiagramm eines Verfahrens zur Herstellung einer Kühlplatte 1 gemäß einer ersten Ausgestaltung der Erfindung dargestellt.

In einem ersten Schritt S1 werden ein erstes und zweites Blech 2, 4 bereitgestellt. Hierbei sind die Bleche 2, 4 bereits hochdruckumgeformt.

In einem zweiten Schritt S2 wird ein als Metallschaum und/oder eine Metallwolle ausgebildeter Füllkörper 42 zwischen den zwei hochdruckumgeformten Blechen 2, 4 angeordnet.

In einem dritten Schritt S3 werden die zwei Bleche 2, 4 zusammen mit dem Füllkörper 42, insbesondere mit dem Metallschaum und/oder der Metallwolle, verpresst.

In einem vierten Schritt S4 werden die Bleche 2, 4 an ihren jeweiligen Enden, insbesondere mittels eines Schweißverfahrens oder eines Lotverfahrens, stoffschlüssig verbunden. Zur Ausbildung der stoffschlüssigen Verbindung ist insbesondere ein Ultraschallschweißverfahren vorteilhaft. Die stoffschlüssige Verbindung ist in der Figur 1 durch die ausgefüllten kreisförmigen Punktflächen angedeutet.

In der Figur 2 ist ein Flussdiagramm eines Verfahrens zur Herstellung einer Kühlplatte 1 gemäß einer zweiten Ausgestaltung der Erfindung dargestellt.

Hierbei zeigt Figur 2 im Wesentlichen die gleichen Elemente wie bereits Figur 1, sodass das unter Figur 1 Gesagte unmittelbar auf Figur 2 übertragen werden kann.

Im Unterschied zu Figur 1 ist in Figur 2 der Füllkörper 2 durch mittels eines Druckgusses hergestellte Rippen 42 oder durch eine Rippenstruktur 42 ausgebildet. Durch die Rippen 42 beziehungsweise Rippenstruktur 42 wird die Kühlplatte 1 zum einen mechanisch stabilisiert. Zum anderen wird die thermische Wärmeleitfähigkeit der Kühlplatte 1 verbessert.

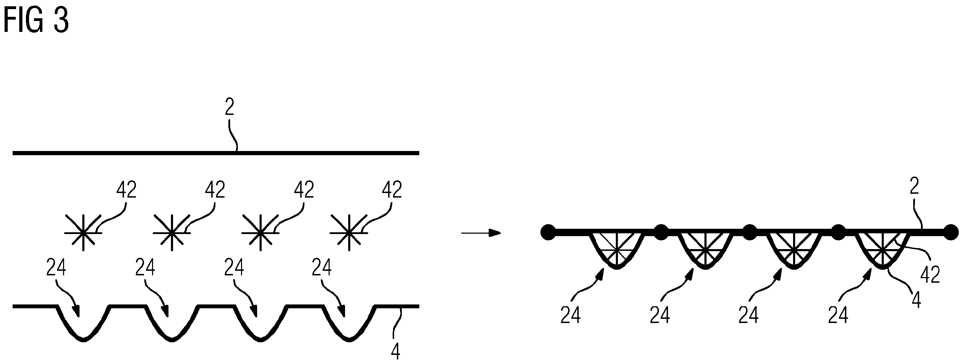

In der Figur 3 ist ein Flussdiagramm eines Verfahrens zur Herstellung einer Kühlplatte 1 gemäß einer dritten Ausgestaltung der Erfindung dargestellt.

Wie bereits bei Figur 2 zeigt Figur 3 im Wesentlichen die gleichen Elemente wie bereits Figur 1, sodass das unter Figur 1 Gesagte unmittelbar auf Figur 3 übertragen werden kann.

In der Figur 3 weist das zweite Blech 4 eine Mehrzahl von Ausbeulungen 24 auf, die beabstandet zueinander entlang einer Längsausrichtung des zweiten Bleches 4 angeordnet sind.

Vorab oder durch das Verpressen der zwei Bleche 2, 4 wird ein rippenförmiger und sternförmiger Füllkörper 42 innerhalb der Ausbeulungen 24 angeordnet. Anschließend werden die zwei Bleche 2, 4 jeweils zwischen zwei benachbarten Ausbeulungen 24 stoffschlüssig, insbesondere mittels eines Schweißverfahrens, Ultraschallschweißverfahren und/oder eines Lötverfahrens, miteinander verbunden. Weiterhin werden, wie bereits in Figur 1, die jeweiligen beiden Enden der zwei Bleche 2, 4 stoffschlüssig miteinander verbunden.

Durch die Anordnung des rippenförmigen und sternförmigen Füllkörpers 42 innerhalb der Ausbeulungen 24 und dem Verpressen sowie stoffschlüssigen Verbinden wird eine Mehrzahl von vorteilhaften Kühlkanälen gebildet. Ein zur Kühlung vorgesehenes Kühlfluid kann durch die genannten ausgebildeten Kühlkanäle geführt werden. Dadurch wird eine thermisch besonders vorteilhafte sowie kostengünstige Kühlplatte 1 bereitgestellt.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

## Patentansprüche

1. Verfahren zur Herstellung einer Kühlplatte (1) für einen Leistungshalbleiter, umfassend die Schritte:
- Bereitstellen eines ersten und zweiten Bleches (2, 4);
- Anordnen eines Füllkörpers (42) zwischen dem ersten und zweiten Blech (2, 4);
- Verpressen der Bleche (2, 4) mit dem zwischen den Blechen (2, 4) angeordneten Füllkörper (42); und
- Stoffschlüssiges Verbinden des ersten und zweiten Bleches (2, 4) an ihren jeweiligen Enden.

2. Verfahren gemäß Anspruch 1, bei dem als Bleche (2, 4) hochdruckgeformte Bleche verwendet werden.

3. Verfahren gemäß Anspruch 1 oder 2, bei dem die ersten und zweiten Bleche (2, 4) mittels eines Schweißverfahrens, insbesondere mittels eines Ultraschallschweißverfahrens, und/oder mittels eines Lötverfahrens stoffschlüssig an ihren jeweiligen Enden verbunden werden.

4. Verfahren gemäß einem der vorhergehenden Ansprüche, bei dem als Füllkörper (42) ein Metallschaum und/oder eine Metallwolle verwendet werden/wird.

5. Verfahren gemäß einem der vorhergehenden Ansprüche, bei dem als Füllkörper (42) ein Druckgussprofil, insbesondere mittels eines Druckgusses hergestellte Rippen, verwendet wird.

6. Verfahren gemäß Anspruch 5, bei dem als Füllkörper (42) ein Druckgussprofil mit wenigstens einem Sacklochgewinde und einer Dichtung verwendet wird.

7. Verfahren gemäß einem der vorhergehenden Ansprüche, bei dem als Füllkörper (42) ein mittels eines generativen Fertigungsverfahren, insbesondere mittels dreidimensionalen Druckens, hergestelltes Bauteil verwendet wird.

8. Verfahren gemäß einem der vorhergehenden Ansprüche, bei dem wenigstens eines der Bleche (2, 4) mit einer Mehrzahl von Ausbeulungen (24) bereitgestellt wird.

9. Verfahren gemäß Anspruch 8, bei dem als Füllkörper (42) eine Mehrzahl von einzelnen Druckgussprofilen verwendet wird, und bei dem die einzelnen Druckgussprofile vor dem Verpressen oder bei dem Verpressen der Bleche (2, 3) innerhalb der Ausbeulungen (24) angeordnet werden.

10. Verfahren gemäß Anspruch 9, bei dem die zwei Bleche (2, 4) zwischen zwei benachbarten Ausbeulungen (24) stoffschlüssig, insbesondere mittels eines Schweißverfahrens, Ultraschallschweißverfahren und/oder eines Lötverfahrens, miteinander verbunden werden.

11. Modul, umfassend wenigstens einen Leistungshalbleiter der an wenigstens einer Kühlplatte (1) angeordnet ist, **dadurch gekennzeichnet, dass** die Kühlplatte (1) mittels eines Verfahrens gemäß einem der Ansprüche 1 bis 10 hergestellt ist.

12. Stromrichter, **dadurch gekennzeichnet, dass** dieser wenigstens ein Modul gemäß Anspruch 11 umfasst.
